# EUROPÄISCHE PATENTANMELDUNG

(11) **EP 0 756 445 A1**
(43) Veröffentlichungstag der Anmeldung: **29.01.1997**
(21) Anmeldenummer: 96110224.1
(22) Anmeldetag: 25.06.1996
(51) Int. Cl.: H05K 9/00

(54) **Baugruppenträger**

(30) Priorität: 27.06.1995 DE 19523257
(71) Anmelder: AEG Intermas GmbH, 60596 Frankfurt (DE)
(72) Erfinder: Haxel,Gerd, 63500 Seligenstadt (DE); Ponto,Robert, 63500 Seligenstadt (DE); Bohnenberger,Willy, 63533 Mainhausen (DE)
(74) Vertreter: Stoffregen, Hans-Herbert, Dr. Dipl.-Phys.

(57) **Zusammenfassung**

Gegenstand der Erfindung ist ein Baugruppenträger mit zwei metallischen Seitenwänden, zwischen denen an den vier Ecken jeweils Profilschienen aus Metall verlaufen, die an den Seitenwänden befestigt sind und Führungshalter tragen, in denen Baugruppen angeordnet sind. Eine obere und/oder untere metallische Abdeckplatte ist jeweils elektrisch leitend mit den vorderen und rückseitigen Profilschienen und den Seitenwänden verbunden. Die metallischen oder metallisierten Frontplatten der Baugruppen sind über eine Blattfeder mit den vorderen Profilschienen leitend verbunden. Die vorderen Profilschienen weisen jeweils eine zur Vorderseite des Baugruppenträgers hin offene Nut auf, die einen Abschnitt mit breiterem Querschnitt für mindestens eine Gewindeleiste oder für Gleitmuttern enthält. Die Blattfeder (3, 3a) weist einen Fixierteil auf, der unter Federvorspannung die Schenkel (400, 400a) der Profilschiene (4, 4a) umschließt und so die Blattfeder (3, 3a) an den Profilschienen (4, 4a) befestigt und elektrisch Kontakt herstellt. Mindestens drei Seitenwände des Schenkels (41, 42, 43, 43a) liegen außerhalb der Nut (8, 8a), wobei die Blattfeder (3, 3a) federnde Teile (35) aufweist, mit dem der elektrische Kontakt mit der Frontplatte (20) und der Profilschiene (4, 4a) in eingeschobenem Zustand hergestellt wird.

## Beschreibung

Die Erfindung bezieht sich auf einen Baugruppenträger mit zwei metallischen Seitenwänden, zwischen denen an den vier Ecken jeweils Profilschienen aus Metall verlaufen, die an den Seitenwänden befestigt sind und Führungshalter tragen, in denen Baugruppen angeordnet sind, wobei eine obere und/oder untere metallische Abdeckplatte jeweils elektrisch leitend mit den vorderen und rückseitigen Profilschienen und den Seitenwänden verbunden sind und wobei die metallischen oder metallisierten Frontplatten der Baugruppen über eine Blattfeder mit den vorderen Profilschienen leitend verbunden sind, und die vorderen Profilschienen jeweils eine zur Vorderseite des Baugruppenträgers hin offene Nut aufweisen, die einen Abschnitt mit breiterem Querschnitt für mindestens eine Gewindeleiste oder für Gleitmuttern aufweist. Ein derartiger Baugruppenträger ist aus der DE 41 26 576 A1 bekannt.

Bei dem in der DE 41 14 484 A1 genannten DE-OS beschriebenen Baugruppenträger wird für die Frontplatten eine besondere Art von Gleitfedern verwendet, die je in einen der U-förmigen Schenkel eingesetzt sind und an dem Schenkel der benachbarten Frontplatte anliegen, um eine gute Abschirmung gegen hochfrequente Störfelder an den vertikalen Spalten zwischen den Frontplatten benachbarter Baugruppen herzustellen.

Blattfedern haben eine weiche Federcharakteristik, wodurch die beim Einschieben der Baugruppen in die Steckplätze der Magazine und beim Herausziehen aus den Steckplätzen aufzuwendenden Kräfte trotz guter Abschirmwirkung relativ gering sind. Außerdem werden dadurch auch störende Querkräfte kleingehalten. Zu große Querkräfte können bei einem nichtbesetzten Baugruppenplatz unerwünschte seitliche Versetzungen der übrigen Baugruppen in Richtung der Lücke hervorrufen.

Die Baugruppen bestehen im allgemeinen aus einer Steckplatte, auf der elektronische Baugruppen angeordnet sind, einer Frontplatte und einer oder mehreren Messerleisten bzw. Federleisten. An den über die Stirnseite der Steckplatte hinausragenden Enden kann die jeweilige Frontplatte mittels einer Schraubverbindung an dem Baugruppenträger befestigt werden. Die oberen und unteren frontseitigen Profilschienen der Baugruppenträger weisen längliche Nuten auf, in die Gewindeleisten eingesetzt sind, in die die befestigten Schrauben der Frontplatte eingeschraubt sind.

Frontplatten können im 19''-Aufbausystem Breiten zwischen einem Basismaß von 5,08 mm und einem Vielfachen dieses Basismaßes aufweisen. Breitere Frontplatten sind vor allem an Steckblöcken vorhanden, die zur Aufnahme von schwereren bzw. voluminösen elektrischen Bauelementen eingesetzt werden. Bei breiteren Frontplatten sind in der Regel Schraubverbindungen an den vier Ecken vorgesehen. Im Bereich der Schraubverbindungen ergeben sich Auflageflächen zwischen metallischen Frontplatten und metallischen Profilschienen, die einen geringen elektrischen Übergangswiderstand haben und für die Abschirmung von Störfeldern geeignet sind. Insbesondere bei breiteren Frontplatten werden die oberen Ränder der Frontplatte nicht mit den erwünschten gleichmäßigen Andruckkräften an den Profilschienen anliegen. Deshalb können Stellen mit nicht ausreichender Abschirmwirkung vorkommen.

Aus der DE 41 26 576 A1 ist es bekannt, an denjenigen Stellen der Frontplatten, denen Profilschienen zugewandt sind, eine gute Abschirmwirkung durch niederohmige Kontaktflächen in ausreichender Zahl dadurch zu erreichen, daß die vorderen oberen und unteren Profilschienen jeweils eine zur Vorderseite des Baugruppenträgers offene Nut mit zwei Abschnitten aufweisen, wobei der hintere Abschnitt zur Aufnahme von Gewindeleisten oder Gleitmuttern vorgesehen ist und der vordere Abschnitt eine Blattfeder unter Federvorspannung enthält, deren einer Teil aus der Nut herausragt und so die elektrische Verbindung zwischen der oberen bzw. unteren Profilschiene und der Frontplatte des Baugruppenträgers herstellt, wenn die Baugruppe in den Baugruppenträger eingeschoben ist.

Nachteilig hierbei ist es, daß die Blattfeder und die Gewindeleiste exakt aufeinander abgestimmt sein müssen und so erhöhte Anforderungen an die einzuhaltenden Toleranzen gestellt werden.

Weiterhin verhaken sich vielfach die in die Gewindeleisten eingesetzten Schrauben mit der jeweiligen Feder.

Aufgabe der vorliegenden Erfindung ist es daher, einen Baugruppenträger anzugeben, der keine erhöhte Anforderung an die Toleranzen aufweist, leicht zu montieren und dadurch wirtschaftlicher ist und ein problemloses Einsetzen der Schrauben in die Gewindeleisten oder Gleitmuttern ermöglicht.

Diese Aufgabe wird erfindungsgemäß durch einen Baugruppenträger mit den Merkmalen des Anspruchs 1 gelöst.

Dadurch, daß der Fixierteil der Blattfeder den Schenke der Profilschiene im wesentlichen außerhalb der Nut umgibt und nur maximal ein Abschnitt sich in der Nut mit der Gewindeleiste befindet, können sich die Blattfeder und die Gewindeleiste bzw. die in die Gewindeleiste einzudrehenden Schrauben nicht gegenseitig behindern. Die erfindungsgemäße Blattfeder kann einfach ohne Werkzeuge montiert werden. Man setzt sie auf die Profilschiene auf und drückt sie so lange, bis das äußere Ende der Blattfeder eine Kante hintergreift und schon ist die Blattfeder fixiert und behindert nicht das Anschrauben der Frontplatten. Auch ist die Lage der Bohrung der Gewindeleiste frei wählbar. Erhöhte Anforderungen an die Toleranz der Abmessung der Blattfeder sind ebenfalls nicht vorhanden.

Die Erfindung wird nachfolgend anhand der Figuren für zwei besonders bevorzugte Ausführungsformen der Blattfeder näher beschrieben.

Es zeigen:

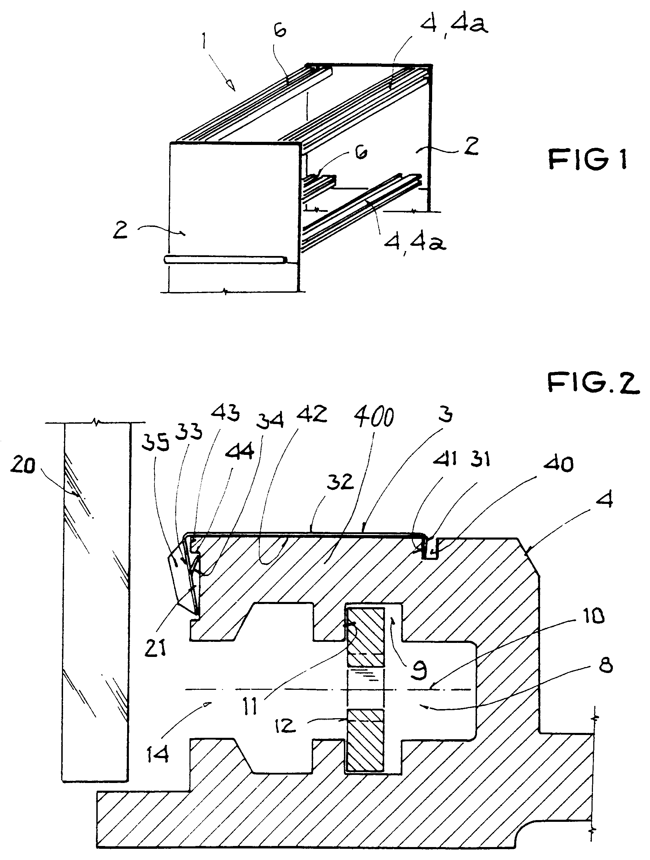

- Fig. 1: einen Baugruppenträger in perspektivischer Ansicht;
- Fig. 2: eine vordere Profilschiene des Baugruppenträgers im Querschnitt;
- Fig. 3: eine Blattfeder für die Profilschiene aus Fig. 2 in Ansicht und im Schnitt in entspanntem Zustand;
- Fig. 4: die Montage der Blattfeder aus Fig. 3;
- Fig. 5: eine andere Profilschiene des Baugruppenträgers im Querschnitt;
- Fig. 6: eine Blattfeder für die Profilschiene aus Fig. 5 in Ansicht und im Schnitt;
- Fig. 7: die Montage der Blattfeder aus Fig. 6 und
- Fig. 8: mehrere zusammenhängende Blattfedern aus Fig. 5

Nachstehend werden für gleiche Bauteile gleiche Bezugszeichen verwendet. Ein Baugruppenträger 1 für die Aufname von elektrischen oder elektronischen Baugruppen enthält zwei ebene, rechteckige Seitenwände 2, die über Profilschienen 4, 6 oder 4a, 6 miteinander verbunden sind. Die Profilschienen 4, 4a befinden sich an der Vorderseite des Baugruppenträgers 1, während die Profilschienen 6 an der rückwärtigen Seite des Baugruppenträgers 1 angeordnet sind. Die Profilschienen 4, 4a und 6 sind gleich lang und verlaufen quer zu den Seitenwänden 2. Die Profilschienen 4, 4a und 6 weisen an ihren stirnseitigen Enden jeweils nicht näher dargestellte Gewindelöcher auf und sind mit Stahlschrauben an den Seitenwänden 2 befestigt.

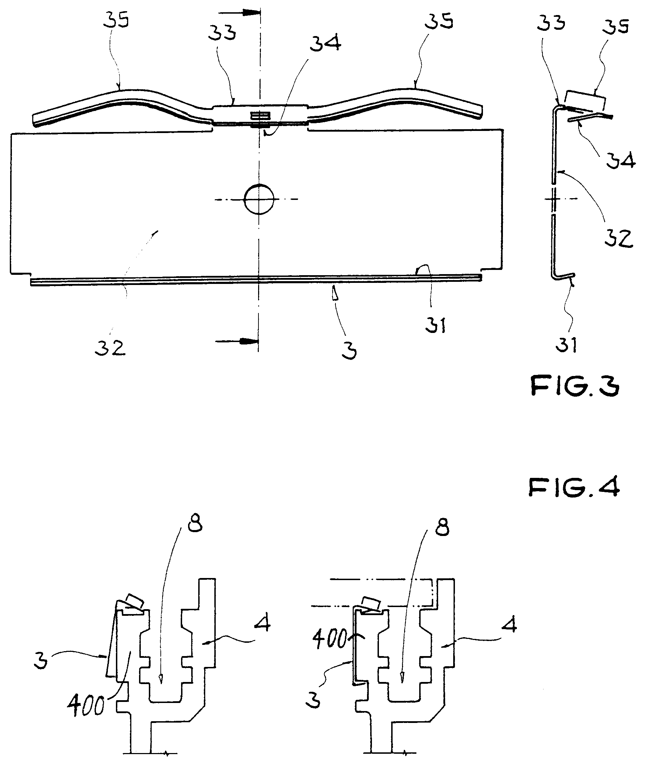

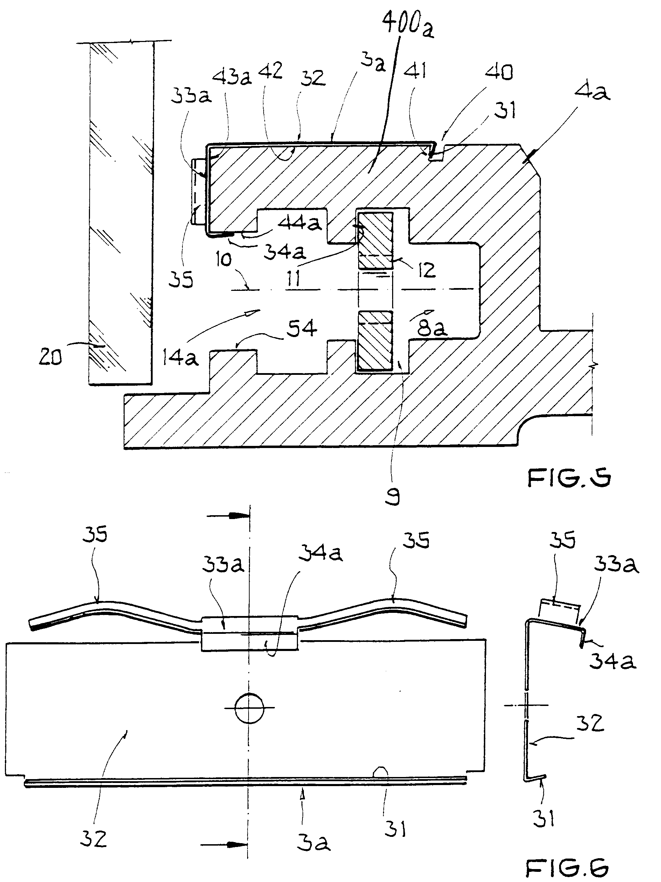

Die Profilschienen 4 haben in ihrem vorderen, der Vorderseite des Baugruppenträgers 1 zugewandten Teil das in Fig. 2 dargestellte Querschnittsprofil, die Profilschienen 4a das in Fig. 5 dargestellte Querschnittsprofil.

Die Profilschiene 4 ist mit einer länglichen Nut 8 versehen, die sich über die gesamte Länge erstreckt. Die Nut 8 ist auf der Vorderseite der Profilschiene offen. In der Nut 8 befindet sich ein Abschnitt 9 mit größerem Querschnitt, der symmetrisch zur Mittelebene 10 der Nut 8 verläuft. Durch die Querschnittsvergrößerung werden zwei Auflageflächen 11 gebildet, die für Gleitmuttern oder Gewindeleisten bestimmt sind, von denen eine Gewindeleiste 12 in Fig. 2 dargestellt ist. Es kann sich dabei um eine über die ganze Länge der Nut 8 verlaufende Gewindeleiste oder um einzelne, aneinander grenzende Gewindeleistenabschnitte handeln. Die Profilschiene 4 weist auf ihren Außenseiten zwei weitere längliche Nuten 21, 40 auf, die sich ebenfalls über die gesamte Länge erstrecken. Nut 21 verläuft neben der Öffnung 14 der Nut 8 quer zur Mittelebene 10, Nut 40 verläuft auf der Seite der Profilschiene 4. Die eine Seite der Nut 21 wird durch die Seitenwand 44 gebildet, daran schließt sich im rechten Winkel die Seitenwand 43 an, an diese im rechten Winkel die Schenkelaussenwand 42. Schließlich wird die Schenkelaussenwand 42 durch die Seitenwand 41 begrenzt, die zur Schenkelaussenwand 42 ebenfalls einen Winkel von 90° einnimmt. Seitenwand 41 ist eine Seitenfläche der Nut 40. Die vorgenannten Seitenwände 41, 43 und 44 sind Seitenteile des Schenkels 400 der Profilschiene 4. Die Blattfeder 3 umfaßt unter Vorspannung im wesentlichen den Schenkel 400 und ist somit elektrisch und mechanisch mit dem Profil 4 verbunden. Die Blattfeder 3 weist ein Basisteil 32 auf, an dessen einem Ende sich eine erste Abkantung 31 anschließt, wobei zwischen dem Basisteil 32 und der Abkantung 31 in entspanntem Zustand (Fig. 3) ein Winkel β < 90° eingeschlossen wird, vorteilhafterweise beträgt der Winkel β ca. 80°. An der anderen Seite des Basisteils 32 schließt sich eine zweite Abkantung 33 an, die mit dem Basisteil 32 einen Winkel α < 90° einschließt. Vorteilhafterweise beträgt der Winkel α ca. 80°. Von der zweiten Abkantung 33 ist ein weiterer Abschnitt in Form eines Hakens 34 in spitzem Winkel derart angeordnet, daß seine Spitze in entspanntem Zustand der Blattfeder 3 auf das Basisteil 32 zeigt. Von der zweiten Abkantung 33 gehen zwei gebogene Federzungen 35 in entgegengesetzter Richtung ab, die sich in eingeschobenem Zustand der Frontplatte 20 an diese anlegen und so den elektrischen Kontakt zwischen der Blattfeder 3 zur Frontplatte 20 und zur Profilschiene 4 herstellen. Diese Anordnung ist besonders vorteilhaft, da auf diese Weise für zwei Federzungen 35 nur ein kurzer Abschnitt 33 benötigt wird und dadurch Platz gewonnen wird für eine größere Anzahl Federzungen 35, als dies möglich wäre, wenn nur eine Federzunge 35 pro Abkantung 33 vorgesehen ist. Zum Einbau der Blattfeder 3 wird das Profil vorteilhafterweise so in Position gebracht, daß die Nut 8 nach oben hin offen ist. Die Blattfeder wird mit ihrer zweiten Abkantung 33 so auf die Nut 21 gelegt, daß sich die erste Abkantung 31 in der Nähe der Nut 40 befindet. Durch Druck von oben auf die zweite Abkantung 33 wird der Winkel zwischen dem Basisteil 32 und der zweiten Abkantung 33 aufgebogen, so daß die erste Abkantung 31 nach unten wandert und automatisch in die Nut 40 rutscht und gegen die Seitenwand 41 drückt, gleichzeitig drückt der Haken 34 gegen die Seitenwand 44 und verriegelt so die Blattfeder 3 in der Nut 21. Die Blattfeder 3 bleibt in montiertem Zustand unter Spannung. So wird ein unbeabsichtigtes Lösen verhindert. Die gespannte Blattfeder 3 stellt eine dauerhafte mechanische und elektrische Verbindung zu der Profilschiene 4 her.

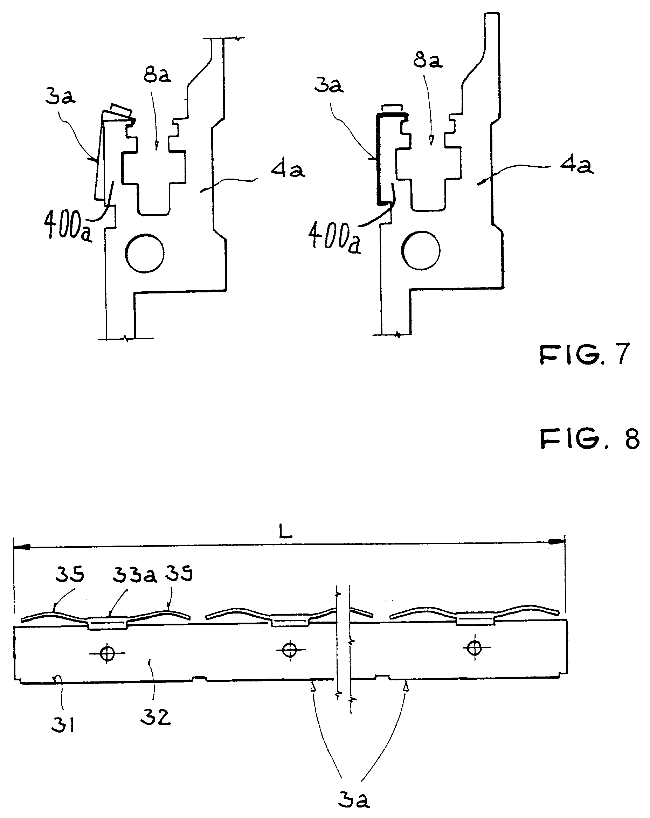

Die Profilschiene 4a unterscheidet sich von der Profilschiene 4 im für die Blattfeder 3a relevanten Bereich dadurch, daß sie keine Nut 21 aufweist, sondern daß die Vorderseite 43a des Schenkels 400a sich von der Öffnung 14a der Nut 8a bis zur Schenkelaussenwand 42 erstreckt. Dementsprechend ist die Blattfeder 3a angepaßt. Die Blattfeder 3a weist wie die Blattfeder 3 das Basisteil 32 und die erste Abkantung 31 auf. Die zweite Abkantung 33a schließt mit dem Basisteil 32 in unbelastetem Zustand einen Winkel α < 90° ein. Weiterhin schließt sich an die zweite Abkantung 33a ein weiterer Abschnitt in Form einer dritten Abkantung 34a an. Die dritte Abkantung 34a drückt im eingebauten Zustand die Blattfeder 3a gegen die Seitenwand 44a. Die Seitenwand 44a ist gleichzeitig eine Seitenfläche der Nut 8a und bildet zusammen mit der Seitenwand 54 die Öffnung 14a der Nut 8a. Der Abstand zwischen der Seitenwand 44a und der Seitenwand 54 ist so groß gewählt, daß Schrauben, die in die Gewindeleiste 12 eingedreht werden sollen, nicht von der dritten Abkantung 34a der Blattfeder 3a behindert werden. Die Blattfeder 3a weist ebenso wie die Blattfeder 3 zwei Federzungen 35 auf. Zur Montage wird die Blattfeder 3a vorteilhafterweise so auf die Profilschiene 4a gesetzt, daß die Abkantung 34a an die Seitenwand 44a stößt. Dann wird auf den kurzen Abschnitt 33a gedrückt, bis Abkantung 31 in Nut 40 einrastet und gegen Seitenwand 41 drückt (Fig. 7).

Vorteilhafterweise werden die Blattfedern 3, 3a nicht einzeln an die Profilschiene 4, 4a eingebaut, sondern mit mehreren Stücken an den Basisteilen 32 derart zusammenhängend, daß sie insgesamt die Länge L der Profilschiene 4, 4a aufweisen, so daß für jede Profilschiene 4, 4a ein einziges Baute benötigt und montiert wird. Fig. 8 zeigt ein derartiges aus mehreren Blattfedern 3a bestehendes Bauteil. Die Blattfedern 3 können entsprechend zusammenhängend hergestellt und montiert werden.

## Patentansprüche

1. Baugruppenträger mit zwei metallischen Seitenwänden, zwischen denen an den vier Ecken jeweils Profilschienen aus Metall verlaufen, die an den Seitenwänden befestigt sind und Führungshalter tragen, in denen Baugruppen angeordnet sind, wobei eine obere und/oder untere metallische Abdeckplatte jeweils elektrisch leitend mit den vorderen und rückseitigen Profilschienen und den Seitenwänden verbunden sind und wobei die metallischen oder metallisierten Frontplatten der Baugruppen über eine Blattfeder mit den vorderen Profilschienen leitend verbunden sind, und die vorderen Profilschienen jeweils eine zur Vorderseite des Baugruppenträgers hin offene Nut aufweisen, die einen Abschnitt mit breiterem Querschnitt für mindestens eine Gewindeleiste oder für Gleitmuttern aufweist,
**dadurch gekennzeichnet,**
daß die Blattfeder (3, 3a) einen Fixierteil aufweist, der an einem die Nut (8, 8a) bildenden Schenkel der Profilschiene (4, 4a) derart befestigt ist, daß der Fixierteil den Schenkel im wesentlichen außerhalb der Nut (8, 8a) unter Federvorspannung umgibt, und daß die Blattfeder (3, 3a) federnde Teile (35) aufweist, mit dem der elektrische Kontakt mit der Frontplatte (20) und der Profilschiene (4, 4a) in eingeschobenem Zustand hergestellt wird.

2. Baugruppenträger nach Anspruch 1,
dadurch gekennzeichnet,
daß die federnden Teile (35) aus Federzungen (35) bestehen.

3. Baugruppenträger nach Anspruch 1 oder 2,
dadurch gekennzeichnet,
daß die Blattfeder (3, 3a) ein Basisteil (32) aufweist, das an der Schenkelaussenwand (42) der Profilschiene (4, 4a) anliegt, daß an einer Seite des Basisteils (32) eine erste Abkantung (31) vorhanden ist, die an die Seitenwand (41) einer Nut (40) in der Schenkelaussenwand drückt,
daß auf der anderen Seite des Basisteils (32) eine zweite Abkantung (33, 33a) vorhanden ist, von der aus ein Abschnitt (34, 34a) gegen eine Seitenwand (44, 44a) einer Nut (21) oder der Nut (8a) drückt, wobei zwischen dem Basisteil (32) und der zweiten Abkantung (33, 33a) im nicht eingebauten Zustand der Blattfeder (3, 3a) ein Winkel α < 90 ° vorhanden ist.

4. Baugruppenträger nach Anspruch 3,
dadurch gekennzeichnet,
daß der Abschnitt (34) ein Haken (34) ist, der gegen die Seitenwand (44) drückt, und daß die Seitenwand (44) parallel zur Nut (8) verläuft.

5. Baugruppenträger nach Anspruch 3,
dadurch gekennzeichnet,
daß der Abschnitt (34a) eine Abkantung (34a) ist, die mit der zweiten Abkantung (33a) im nicht eingebauten Zustand der Blattfeder (3a) einen Winkel β < 90 ° einschließt, und daß der Raum zwischen der Seitenwand (44a) und der gegenüberliegenden Seitenwand (54) so groß ist, daß bei eingebauter Blattfeder (3a) die in die Gewindeleiste (12) einzudrehenden Schrauben beim Einbau nicht behindert werden.
